# EUROPÄISCHE PATENTSCHRIFT

(11) **EP 1 153 440 B1**
(45) Veröffentlichungstag und Bekanntmachung des Hinweises auf die Patenterteilung: **28.05.2003**
(21) Anmeldenummer: 00901026.5
(22) Anmeldetag: 01.02.2000
(51) Int. Cl.: H01L 31/048

(54) **SOLARMODUL**
SOLAR MODULE
MODULE SOLAIRE

(30) Priorität: 01.02.1999 CH 17299
(43) Veröffentlichungstag der Anmeldung: 14.11.2001
(73) Patentinhaber: Kurth Glas + Spiegel AG, 4528 Zuchwil (CH)
(72) Erfinder: KURTH, Martin, CH-4528 Zuchwil (CH)
(74) Vertreter: Spierenburg, Pieter
(86) Internationale Anmeldenummer: CH0000054
(87) Internationale Veröffentlichungsnummer: WO00046860

(56) Entgegenhaltungen:
- EP-A- 0 199 233
- DE-A- 4 128 766
- DE-U- 9 110 719
- DE-U- 29 607 069
- GB-A- 2 101 186
- US-A- 5 022 930
- PATENT ABSTRACTS OF JAPAN vol. 007, no. 013 (E-153), 19. Januar 1983 (1983-01-19) & JP 57 172777 A (NIHON ITA GLASS KK), 23. Oktober 1982 (1982-10-23)

## Beschreibung

Die Erfindung betrifft ein Solarmodul nach dem Oberbegriff des Patentanspruchs 1.

Ein solches Solarmodul ist beispielsweise aus EP-A-0 525 225 bekannt, welches auf einem Glassubstrat aufgebaut ist, das aus 4 mm dickem gehärteten Solarglas besteht. Auf dem Glassubstrat ist ein Schichtaufbau laminiert, der aus einer ersten Kunststofffolie, elektrisch miteinander verschalteten Solarzellen, einer zweiten Kunststofffolie und einer Verbundfolie als Abdeckfolie besteht. Das Laminieren erfolgt im Vakuum bei erhöhter Temperatur, wobei die Kunststofffolien miteinander verschweisst werden und mit dem Glassubstrat einen festen Verbund bilden.

Andererseits ist aus DE-41 28 766 ein Solarmodul mit einer Anzahl von zu einem Solarzellenstring verschalteten Solarzellen bekannt, bei dem eine transparente Trägerscheibe mit einem Siebdruckleitersystem versehen ist. Die Rückseitenkontakte der Solarzellen stehen dabei innerhalb eines Solarzellenstrings mit dem Siebdruckleitersystem in Kontakt. Die Vorderseitenkontakte der Solarzellen sind innerhalb eines Solarzellenstrings in Parallel- oder Serienschaltung je nach dem miteinander und/oder mit den Rückseitenkontakten benachbarter Solarzellen verbunden. Eine transparente Deckscheibe ist mit der Trägerscheibe nach Art einer Verbundsicherheitsglasscheibe durch eine Verbundmasse, z.B. auf Folien- oder Giessharzbasis, verbunden. Die Deckscheibe weist ebenfalls ein Siebdruckleitersystem auf, das innerhalb eines Solarzellenstrings mit den Vorderseitenkontakten der Solarzellen derart in Kontakt steht, dass Vorder- und/oder Rückenseitenkontakte jeweils benachbarter Solarzellen elektrisch miteinander verbunden sind.

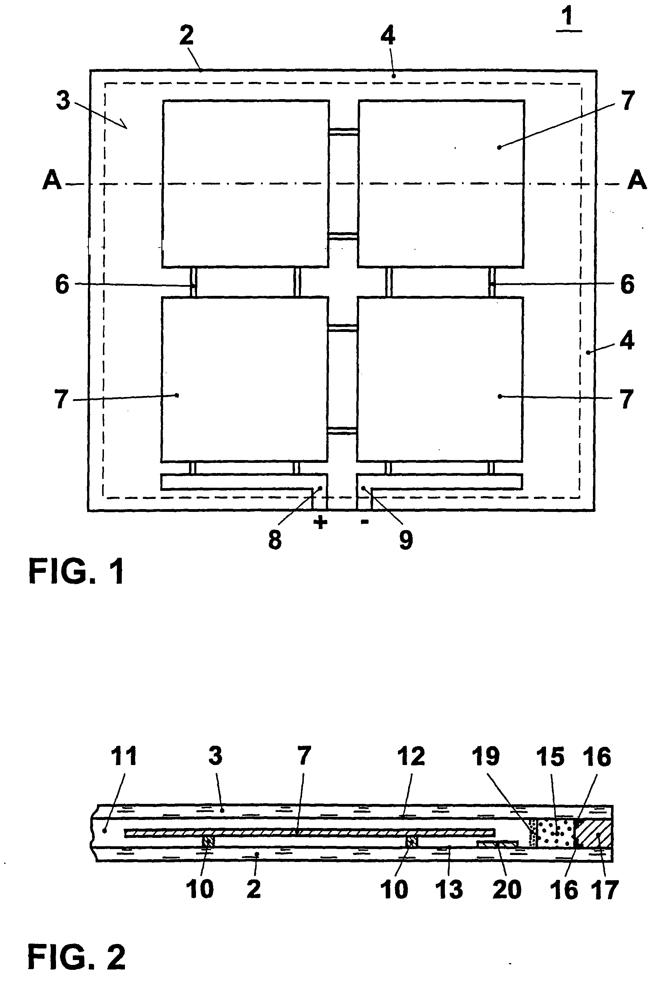

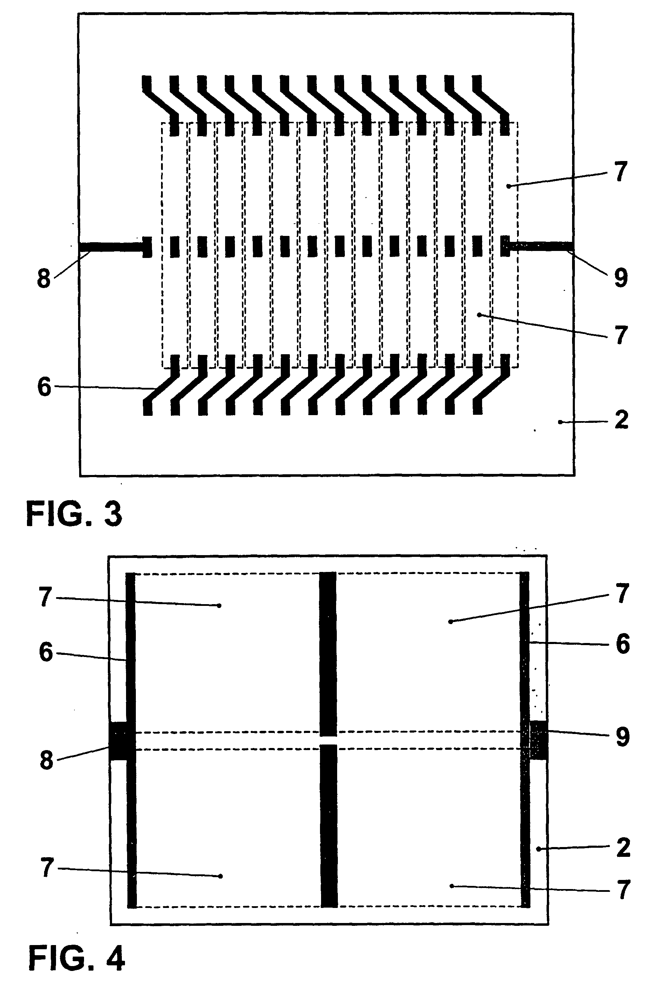

In einem weiteren Ausführungsbeispiel nach der dortigen Fig. 4 bilden die Deckscheibe und die Trägerscheibe die Einzelscheiben einer Isolierglasscheibe, in deren luftgefülltem Scheibenzwischenraum die Solarzellenstrings untergebracht sind. Die Scheiben werden dabei durch Abstandshalter im Randbereich auf dem vorgeschriebenen Abstand gehalten. Zwischen den Solarzellenstrings und den Siebdruckleitersystem der Deckscheibe und der Trägerscheibe sind elektrisch leitende Distanzelemente in Bügel- oder U-Form angeordnet, so dass die Solarzellenstrings nicht direkt, sondern über Distanzelemente mit den Siebdruckleitersystem verlötet sind. Offensichtlich hat dieses Ausführungsbeispiel nur untergeordnete Bedeutung, denn in den Patentansprüchen wird nur auf ein Solarmodul mit einer Verbundmasse auf z.B. Folien- oder Giessharzbasis Bezug genommen, d.h. dass der Zwischenraum mit einer Giesharzmasse ausgefüllt wird, wie in den Ausführungsbeispielen nach den Figuren 1 bis 3 beschrieben.

Die Ausführung der Figur 4 des obengenannten Patentdokumentes ist denn auch aus verschiedenen Gründen kaum wirtschaftlich praktikabel, da schon geringe Spannungen zwischen Deck- und Trägerscheibe zu einem Glasbruch des Solarmoduls führen können. Ausserdem wird durch das Siebdruckleitersystem auf beiden Seiten des Solarmoduls die wirksame Sonneneinstrahlung beeinträchtigt, was einen erheblichen Leistungsverlust mit sich bringen kann. Durch die wechselseitige Schaltung der Solarzellen ergibt sich ein relativ hoher Widerstand, was eine weitere Reduktion der Ausbeute ergibt.

Die bekannten Solarmodule, bei welchen die Solarzellen von einer Kunstofffolie und/oder einer Giessharzmasse umgeben sind, sind kaum für eine Wiederverwendung geeignet, da die Trennung und Entsorgung von Glassubstraten, Kunststofffolien und/oder Giessharz und Leiterbahnen derart aufwendig und somit teuer wird, dass die Entsorgung als Sondermüll wirtschaftlich wesentlich günstiger ist.

Der vorliegenden Erfindung liegt nun die Aufgabe zugrunde, ein Solarmodul der obengenannten Art so zu verbessern, dass ein besonders einfacher Aufbau erhalten wird und die Solarmodule bei Glasbruch oder dergleichen ohne weiteres wiederverwendbar sind.

Diese Aufgabe wird durch ein Solarmodul mit den Merkmalen des Patentanspruchs 1 gelöst.

Das erfindungsgemässe Solarmodul hat den grossen Vorteil, dass die einzelnen Solarzellen relativ einfach austauschbar darin gehalten sind und die Solarzellen dennoch äusserst wirksam gegen Wettereinflüsse wie Wind, Sonneneinstrahlung, Regen und dergleichen geschützt sind. Die durch diese Einwirkungen auf das Solarmodul enstehende Spannungen in den Glassubstraten werden durch die einseitige Verbindung der Solarzellen mit einem einzigen Glassubstrat nicht oder nur unwesentlich auf diese weitergeleitet. Durch den einfachen Aufbau des erfindungsgemässen Solarmoduls ist auch der Energieaufwand für dessen Herstellung gegenüber den herkömmlichen wesentlich geringer, so dass die Herstellungskosten zu einem Drittel oder mehr gesenkt werden können.

Weitere Vorteile der Erfindung folgen aus den abhängigen Patentansprüchen und aus der nachfolgenden Beschreibung, in welcher die Erfindung anhand eines in den schematischen Zeichnungen dargestellten Ausführungsbeispieles näher erläutert wird. Es zeigt:
- Fig. 1: einen schematischen Aufbau eines Solarmoduls in Draufsicht,
- Fig. 2: einen Querschnitt durch das Solarmodul längs der Linie A-A in Fig. 1,
- Fig. 3: eine erste Anordnung der Leiterbahnen auf dem Glassubstrat, und
- Fig. 4: eine zweite Anordnung der Leiterbahnen.

In den Figuren sind für dieselben Elemente jeweils dieselben Bezugszeichen verwendet worden und erstmalige Erklärungen betreffen alle Figuren, wenn nicht ausdrücklich anders erwähnt.

In der Figur 1 ist rein schematisch in Draufsicht ein Solarmodul 1 mit einer als Glassubstrat ausgebildete Trägerplatte 2 und einer als Glassubstrat ausgebildete deckungsgleiche Deckplatte 3 dargestellt, die an ihren Randbereichen von einem gestrichelt dargestellten, dichtenden Abstandsrahmen 4 auf einen festgelegten Abstand zueinander gehalten sind. Das Glassubstrat 2 ist mit Leiterbahnen 6 versehen, auf welchen Solarzellen 7 mittels Lötbrücken befestigt sind. Die Leiterbahnen 6 sind mit nach aussen führenden, als Plus- bzw. Minuspol ausgebildeten Kontaktanschlüssen 8 und 9 versehen. Die Solarzellen 7 können an sich bekannte Silizium- oder Titanzellen oder auch photochemische Zellen sein, wie sie beispielsweise in EP-A-0 525 070 beschrieben.

In Figur 2 ist Teil eines Querschnittes längs der Linie A-A in Figur 1 durch das Solarmodul 1 ersichtlich. Die Solarzellen 7 sind einseitig auf den Leiterbahnen 6 der Trägerplatte 2 mittels der Lötbrücken 10 auf einem Abstand zu den beiden Glassubstraten 2 und 3 befestigt. Es können auch zusätzlich elastische Befestigungselemente wie Klebepunkte mit einem Silikonkleber vorgesehen sein - hier nicht weiter dargestellt. Die Solarzellen 7 sind somit mehr oder weniger frei im luftgefüllten Zwischenraum 11 zwischen den beiden Glassubstraten 2 und 3 angeordnet. Sowohl die Trägerplatte 2 als auch die Deckplatte 3 sind aus einem Silikatglas, vorzugsweise einem Weissglas, mit einer Dicke von unter 5 mm hergestellt. Je nach Anwendung kann für die Herstellung der Glassubstrate 2 und 3 auch ein Silikatglasgemenge aus Altglas verwendet werden. Auf den Innenseiten der beiden Substraten 2 und 3 ist jeweils eine dünne Schicht 12 und 13 einer lichtreflektierenden Farbe mit einem Lichtwert von über 62% aufgebracht. Diese Farbe ist mit Vorteil eine keramische Farbe, auch bekannt als sogenannte Glasfritten. Dazu wird die keramische Farbe im Siebdruckverfahren auf die Glassubstrate aufgetragen und in einem Durchlaufofen bei einer Temperatur von über 600 °C auf die Oberfläche eingebrannt. Auch die Leiterbahnen 6 werden im Siebdruckverfahren als elektrisch leitende Paste, vorzugsweise eine silberhaltige Paste, auf das Glassubstrat 2 aufgedruckt und bei einer Temperatur von über 600 °C eingebrannt. Das Einbrennen der keramischen Farbe und der elektrisch leitenden Paste kann dabei im selben Verfahrenschritt durchgeführt werden. Anstelle der Beschichtung mit einer keramischen Farbe können die Glassubstrate 2 und 3 auch mit einer Oberflächenbehandlung wie Sandstrahlen oder chemisches Ätzen auf ihren äusseren Flächen nicht-reflektierend mit einer hohen Diffusionswirkung gemacht werden. Es können aber auch andere entspiegelte Gläser als Glassubstrate 2 und 3 Verwendung finden. Um Spannungen in den Glassubstraten 2 und 3 auszugleichen, die beispielsweise eine Grösse von 100 cm x 100 cm aufweisen können, werden diese thermisch vorgespannt, d.h. in einem Durchlaufofen mit Rollen auf eine erhöhte Temperatur von etwa 600 °C bis 700 °C erhitzt und dann schockartig mit einem kalten Luftstrom abgekühlt.

Der Abstandsrahmen 4 weist ferner einen vierkanten Glassteg als Abstandshalter 15 auf, der eine Dicke von etwa 6 bis 16 mm, vorzugsweise etwa 8 mm, aufweist. In den äusseren Ecken des Glassteges 15 mit den Glassubstraten 2 und 3 ist eine Dichtung 16 aus Butyl-Kautschuk vorgesehen. Auf der Aussenseite des Glassteges 15 ist sodann eine weitere Dichtung 17 aus einem gummielastischen Material wie Silikonkautschuk oder beispielsweise einem unter dem Markennamen "Bynel" bekannten Schmelzklebstoff oder "hot melt" vorgesehen, die als Wasserdampfsperre für das Solarmodul 1 wirkt. Man könnte aber auch auf die Dichtung 16 verzichten und nur die Dichtung 17 vorsehen. Der Abstandshalter 15 kann auch aus anderen Materialien gefertigt sein, beispielsweise als Holzleiste aus einem Hartholz wie Eiche oder Buche. Auch kann dafür eine Aluminiumleiste vorgesehen sein, die mit einem Schmelzklebstoff ("hot melt") zwischen den Glassubstraten 2 und 3 befestigt wird. Auf der Innenseite des Solarmoduls 1 kann ferner ein Molekularsieb 19 als Trockenmittel, wie beispielsweise Zeolith, vorgesehen sein, um die im Zwischenraum 11 verbleibende Restfeuchte zu verringern und die Solarzellen 6 vor Korrosion zu schützen. Zusätzlich kann ein Feuchtemessgerät 20 im Zwischenraum 11 zwischen den beiden Glassubstraten 2 und 3 angeordnet sein, dessen elektrische Anschlüsse ebenfalls über - hier nicht weiter dargestellte - Leiterbahnen nach aussen geführt sind. Damit kann die Feuchte eines Solarmoduls 1 überwacht und allfällige Leckstellen im Solarmodul 1 festgestellt werden.

In Figur 3 ist nun beispielsweise eine Anordnung von mehreren parallen Leiterbahnfahnen 6 dargestellt, die jeweils mit einer länglichen Solarzelle 7 verlötet sind (gestrichelt dargestellt). Bei der Herstellung wird eine einzige Siliziumplatte auf den Leiterbahnfahnen 6 verlötet und diese anschliessend mit einem Laserstrahl zu den einzelnen länglichen Solarzellen 7 geschnitten. Links und rechts des Glassubstrates oder der Trägerplatte 2 sind die beiden Anschlüsse (Plus- und Minuspol) erkennbar. In Figur 4 ist eine weitere Anordnung der Leiterbahnen 6 ersichtlich, die für die vier gestrichelt dargestellten Solarzellen 7 vorgesehen sind.

Es ist nun auch möglich, dass die Trägerplatte 2 und die Deckplatte 3 nicht genau deckungsgleich übereinander mittels des Abstandsrahmens 4 befestigt sind, sondern mit einem Versatz zueinander. Dadurch können dann mehrere Solarmodule 1 lückenlos aneinander gereiht werden, um einen grösseren Verbund zu bilden. Die so aneinander gereihten Solarmodule 1 können als Wand aufgestellt und eine sogenannte Wetterhaut für eine Gebäudefassade, auf Dächern oder dergleichen bilden.

Es hat sich nun herausgestellt, dass der Energieaufwand für die Herstellung des erfindungsgemässen Solarmoduls 1 in etwa 30 bis 50 kWh pro m² bei einer Dicke der Glassubstraten von 3,5 bis 4,5 mm beträgt. Dies entspricht in etwa 2,2 kWh/kg Glas.

## Patentansprüche

1. Solarmodul (1) mit zwei gegenüberliegenden Glassubstraten (2, 3), die im Randbereich mittels eines dichtenden Abstandsrahmens (4) mit einander verbunden und in deren luftgefüllten Zwischenraum (11) mehrere Solarzellen (7) beabstandet von den Glassubstraten (2, 3) angeordnet sind, wobei die Solarzellen (7) über auf den Glassubstraten aufgebrachte Leiterbahnen (6) elektrisch verbunden sind, **dadurch gekennzeichnet, dass** die Leiterbahnen (6) ausschliesslich auf einem einzigen Glassubstrat (2) aufgebracht und die Solarzellen (7) ausschliesslich auf einem einzigen Glassubstrat (2) mittels flexibler Abstandshalter befestigt sind.

2. Solarmodul nach Anspruch 1, **dadurch gekennzeichnet, dass** die Solarzellen (7) mittels Lötbrücken (10) als flexibler Abstandshalter auf den Leiterbahnen (6) des einzigen Glassubstrates (2) befestigt sind.

3. Solarmodul nach Anspruch 1 oder 2, **dadurch gekennzeichnet, dass** die Solarzellen zusätzlich mittels elastischer Befestigungselemente, vorzugsweise als Klebepunkte aus Silikonkleber, auf dem einzigen Glassubstrat (2) befestigt sind.

4. Solarmodul nach einem der Ansprüche 1 bis 3, **dadurch gekennzeichnet, dass** der Zwischenraum (11) durch den einen Abstandshalter (15) aufweisenden Abstandsrahmen (4) und eine elastische Dichtung (17) nach aussen hermetisch abgedichtet ist.

5. Solarmodul nach Anspruch 4, **dadurch gekennzeichnet, dass** der Abstandshalter (15) von einer elastischen Dichtung (16) aus Butylkautschuk abgedichtet ist.

6. Solarmodul nach Anspruch 4 oder 5, **dadurch gekennzeichnet, dass** die elastische Dichtung (17) aus einem Silikonkautschuk oder einem ausgehärteten Schmelzklebstoff besteht.

7. Solarmodul nach einem der Ansprüche 1 bis 6, **dadurch gekennzeichnet, dass** die Glassubstrate (2, 3) aus Silikatglas, vorzugsweise Weissglas, hergestellt sind und eine Dicke von maximal 5 mm aufweisen.

8. Solarmodul nach Anspruch 7, **dadurch gekennzeichnet, dass** die Glassubstrate (2, 3) vollflächig mit einer lichtreflektierenden Farbe mit einem Lichtwert von mindestens 62% beschichtet sind.

9. Solarmodul nach Anspruch 8, **dadurch gekennzeichnet, dass** die lichtreflektierende Farbe eine keramische Farbe ist.

10. Solarmodul nach Anspruch 7, **dadurch gekennzeichnet, dass** die Glassubstrate (2, 3) eine entspiegelte Oberfläche mit hoher Diffusionswirkung aufweisen.

11. Solarmodul nach einem der Ansprüche 1 bis 10, **dadurch gekennzeichnet, dass** die Leiterbahnen (6) silberhaltig sind.

12. Solarmodul nach einem der Ansprüche 1 bis 11, **dadurch gekennzeichnet, dass** innerhalb des Zwischenraumes (11) Molekularsiebe (19), insbesondere Zeolithe, vorgesehen sind, um die Restfeuchte innerhalb des Solarmoduls herabzusetzen.

13. Solarmodul nach einem der Ansprüche 1 bis 12, **dadurch gekennzeichnet, dass** innerhalb des Zwischenraumes (11) ein Feuchtemessgerät (20) vorgesehen ist, mittels welches Leckstellen im Solarmodul erkennbar sind.

## Claims

1. Solar module (1) with two glass substrates (2, 3) arranged opposite each other which in their border zone are interconnected spaced by a sealing spacer frame (4) and in the air-filled interspace (11) a plurality of solar cells (7) are arranged at a distance with respect to the glass substrates (2, 3) in which arrangement the solar cells (7) are electrically interconnected via conductor leads, **characterized in that** the conductor leads (6) are applied to one glass substrate (2; 3) exclusively, and that the solar cells are fastened to one glass substrate (2; 3) only using flexible spacer elements.

2. Solar module according to claim 1, **characterized in that** the solar cells (7) are fastened to the glass substrate (2; 3) using soldering bridges (10 as flexible connections.

3. Solar module according to claim 1 or 2, **characterized in that** the solar cells are additionally fastened to the one glass substrate (2) by means of elastic fastening elements, preferably as binding points formed by a silicion adhesive.

4. Solar module according one of claims 1 to 3, **characterized in that** the interspace (11) is hermetically sealed from the outside room by a spacer frame (4) having a spacer element (15) and an additional elastic seal (17).

5. Solar module according to claim 4, **characterized in that** the spacer element (15) is sealed by an elastic seal (16) comprising butyl rubber.

6. Solar module according to claim 4 or 5, **characterized in that** the elastic seal (17) comprises a silicon rubber or a hardened melt adhesive.

7. Solar module according to one of claims 1 to 6, **characterized in that** the glass substrates (2, 3) are made from silicate glass, preferentially from colourless (white) glass, and have a maximum thickness of 5 mm.

8. Solar module according to claim 7, **characterized in that** the glass substrates (2, 3) are coated on their whole surface with a light-reflecting paint presenting a light reflectance value of at least 62%.

9. Solar module according to the claim 8, **characterized in that** the light reflecting paint is a ceramic paint.

10. Solar module according to claim 7, **characterized in that** the glass substrates (2, 3) are provided with a non-reflecting surface having a high diffusion effect.

11. Solar module according to one of claims 1 through 9, **characterized in that** the conductor leads (6) comprise silver.

12. Solar module according to one of claims 1 to 11, **characterized in that** within the interspace (11) molecular filters (19), in particular zeolites, are provided in order to reduce the residual humidity within the solar module.

13. Solar module according to one of claims 1 to 12, **characterized in that** within the interspace (11) a humidity monitoring gauge (20) is provided by means of which leaks in the solar module can be detected.

## Revendications

1. Module solaire (1) avec deux substrats de verre (2, 3) superposés qui sont reliés l'un à l'autre dans la zone de bordure au moyen d'un cadre d'écartement (4) formant étanchéité et dans l'espace intermédiaire (11) rempli d'air desquels plusieurs cellules solaires (7) sont disposées avec un écart par rapport aux substrats de verre (2, 3), les cellules solaires (7) étant reliées électriquement par l'intermédiaire de réseaux de circuits imprimés (6) déposés sur les substrats de verre, **caractérisé en ce que** les réseaux de circuits imprimés (6) sont fixés sur un seul substrat (2) et les cellules solaires (7) sont fixées exclusivement sur un seul substrat de verre (2) au moyen d'écarteurs souples.

2. Module solaire selon la revendication 1, **caractérisé en ce que** les cellules solaires (7) sont fixées au moyen de straps (10), comme écarteurs souples, sur les réseaux de circuits imprimés (6) de l'unique substrat de verre (2).

3. Module solaire selon la revendication 1 ou 2, **caractérisé en ce que** les cellules solaires sont fixées en outre au moyen d'éléments de fixation élastiques, de préférence comme des points adhésifs en colle au silicone, sur l'unique substrat de verre (2).

4. Module solaire selon l'une des revendications là 3, **caractérisé en ce que** l'espace intermédiaire (11) est rendu étanche hermétiquement vers l'extérieur par le cadre d'écartement (4) présentant un écarteur (15) et un joint élastique (17).

5. Module solaire selon la revendication 4, **caractérisé en ce que** l'écarteur (15) est rendu étanche par un joint élastique (16) en caoutchouc butyle.

6. Module solaire selon la revendication 4 ou 5, **caractérisé en ce que** le joint élastique (17) est en caoutchouc au silicone ou en colle fusible durcie.

7. Module solaire selon l'une des revendications 1 à 6, **caractérisé en ce que** les substrats de verre (2, 3) sont réalisés en verre aux silicates, de préférence en verre blanc, et présentent une épaisseur maximale de 5 mm.

8. Module solaire selon la revendication 7, **caractérisé en ce que** les substrats de verre (2, 3) sont enduits sur toute leur surface d'une peinture réfléchissant la lumière avec un coefficient d'au moins 62%.

9. Module solaire selon la revendication 8, **caractérisé en ce que** la peinture réfléchissant la lumière est une peinture céramique.

10. Module solaire selon la revendication 7, **caractérisé en ce que** les substrats de verre (2, 3) présentent une surface antireflet avec un effet de diffusion élevé.

11. Module solaire selon l'une des revendications 1 à 10, **caractérisé en ce que** les réseaux de circuits imprimés (6) contiennent de l'argent.

12. Module solaire selon l'une des revendications 1 à 11, **caractérisé en ce que** des tamis moléculaires (19), en particulier des zéolithes, sont prévus à l'intérieur de l'espace intermédiaire (11) pour abaisser l'humidité résiduelle à l'intérieur du module solaire.

13. Module solaire selon l'une des revendications 1 à 12, **caractérisé en ce qu'**un hygromètre (20) est prévu, au moyen duquel des points de fuite peuvent être détectés dans le module solaire.
